Europäisches Patentamt

European Patent Office

Office européen des brevets

(19)

(11) **EP 0 905 680 B1**

(12) **EUROPEAN PATENT SPECIFICATION**

(45) Date of publication and mention
of the grant of the patent:
**04.06.2003 Bulletin 2003/23**

(51) Int Cl.[7]: **G10L 13/00**

(21) Application number: **98306903.0**

(22) Date of filing: **27.08.1998**

(54) **Method for quantizing LPC parameters using switched-predictive quantization**

Verfahren zur Quantisierung der LPC Parameter mittels geschalteter prädiktiver Quantisierung

Procédé de quantisation des paramètres LPC utilisant une quantisation prédictive commutée

(84) Designated Contracting States:
**DE FR GB IT NL**

(30) Priority: **28.08.1997 US 57119 P**

(43) Date of publication of application:
**31.03.1999 Bulletin 1999/13**

(73) Proprietor: **TEXAS INSTRUMENTS INC.**
**Dallas, Texas 75243 (US)**

(72) Inventor: **McCree, Alan V.**
**Dallas, Texas 75248 (US)**

(74) Representative: **Potter, Julian Mark et al**
**D. Young & Co.,**
**21 New Fetter Lane**
**London EC4A 1DA (GB)**

(56) References cited:
**EP-A- 0 751 494          EP-A- 0 899 720**

• **MCCREE A ET AL: "A 1.6 kb/s MELP coder for wireless communications" 1997 IEEE WORKSHOP ON SPEECH CODING FOR TELECOMMUNICATIONS PROCEEDINGS. BACK TO BASICS: ATTACKING FUNDAMENTAL PROBLEMS IN SPEECH CODING (CAT. NO.97TH8295), 1997 IEEE WORKSHOP ON SPEECH CODING FOR TELECOMMUNICATIONS PROCEEDINGS. BACK TO BASICS: ATTACK, pages 23-24, XP002110685 1997, New York, NY, USA, IEEE, USAISBN: 0-7803-4073-6**

• **MOO YOUNG KIM ET AL: "Spectral envelope quantization with noise robustness" 1997 IEEE WORKSHOP ON SPEECH CODING FOR TELECOMMUNICATIONS PROCEEDINGS. BACK TO BASICS: ATTACKING FUNDAMENTAL PROBLEMS IN SPEECH CODING (CAT. NO.97TH8295), 1997 IEEE WORKSHOP ON SPEECH CODING FOR TELECOMMUNICATIONS PROCEEDINGS. BACK TO BASICS: ATTACK, pages 77-78, XP002110686 1997, New York, NY, USA, IEEE, USAISBN: 0-7803-4073-6**

• **ZARRINKOUB H ET AL: "Switched prediction and quantization of LSP frequencies" 1996 IEEE INTERNATIONAL CONFERENCE ON ACOUSTICS, SPEECH, AND SIGNAL PROCESSING CONFERENCE PROCEEDINGS (CAT. NO.96CH35903), 1996 IEEE INTERNATIONAL CONFERENCE ON ACOUSTICS, SPEECH, AND SIGNAL PROCESSING CONFERENCE PROCEEDINGS, ATLANTA, GA, USA, 7-10 M, pages 757-760 vol. 2, XP002110687 1996, New York, NY, USA, IEEE, USAISBN: 0-7803-3192-3**

• **RAMACHANDRAN R P ET AL: "A TWO CODEBOOK FORMAT FOR ROBUST QUANTIZATION OF LINE SPECTRAL FREQUENCIES" IEEE TRANSACTIONS ON SPEECH AND AUDIO PROCESSING, vol. 3, no. 3, 1 May 1995 (1995-05-01), pages 157-167, XP000633059 ISSN: 1063-6676**

EP 0 905 680 B1

**Description**

TECHNICAL FIELD OF THE INVENTION

This invention relates to switched-predictive quantization.

BACKGROUND OF THE INVENTION

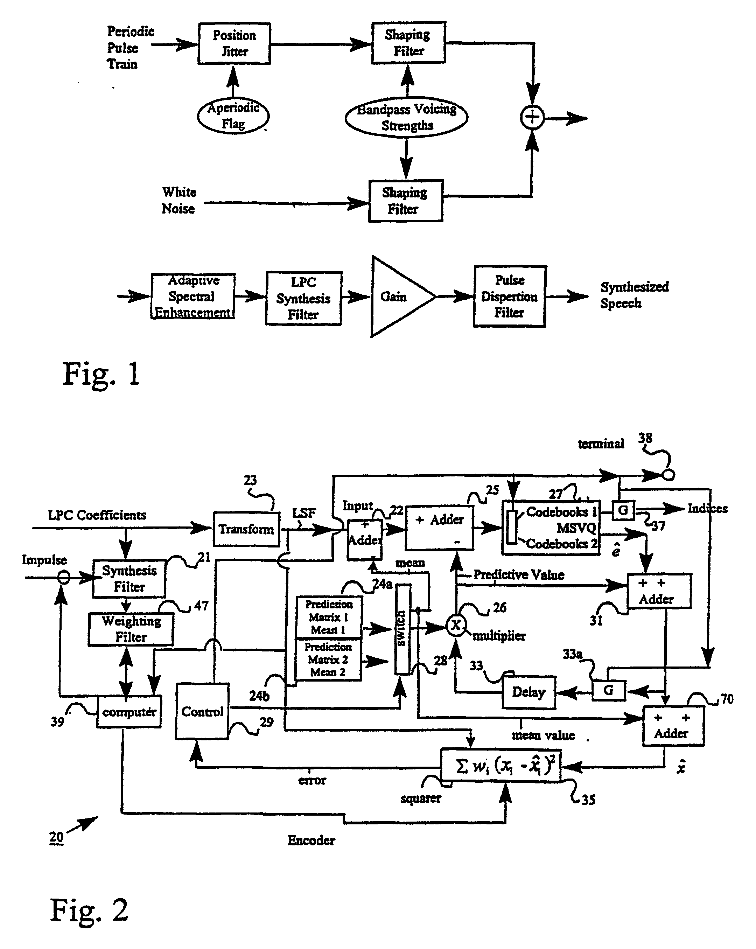

Many speech coders, such as the new 2.4 kb/s Federal Standard Mixed Excitation Linear Prediction (MELP) coder (McCree, et al., entitled, "A 2.4 kbits/s MELP Coder Candidate for the New U. S. Federal Standard," Proc. ICASSP-96, pp. 200-203, May 1996.) use some form of Linear Predictive Coding (LPC) to represent the spectrum of the speech signal. An MELP coder is described in the Applicant's co-pending U.S. Patent Application Serial No. 08/650,585, entitled "Mixed Excitation Linear Prediction with Fractional Pitch," filed 05/20/96. Fig. 1 illustrates such a MELP coder. The MELP coder is based on the traditional LPC vocoder with either a periodic impulse train or white noise exciting a 10th order on all-pole LPC filter. In the enhanced version, the synthesizer has the added capabilities of mixed pulse and noise excitation periodic or aperiodic pulses, adaptive spectral enhancement and pulse dispersion filter as shown in Fig. 1. Efficient quantization of the LPC coefficients is an important problem in these coders, since maintaining accuracy of the LPC has a significant effect on processed speech quality, but the bit rate of the LPC quantizer must be low in order to keep the overall bit rate of the speech coder small. The MELP coder for the new Federal Standard uses a 25-bit multi-stage vector quantizer (MSVQ) for line spectral frequencies (LSF). There is a 1 to 1 transformation between the LPC coefficients and LSF coefficients.

Quantization is the process of converting input values into discrete values in accordance with some fidelity criterion. A typical example of quantization is the conversion of a continuous amplitude signal into discrete amplitude values. The signal is first sampled, then quantized.

For quantization, a range of expected values of the input signal is divided into a series of subranges. Each subrange has an associated quantization level. For example, for quantization to 8-bit values, there would be 256 levels. A sample value of the input signal that is within a certain subrange is converted to the associated quantizing level. For example, for 8-bit quantization, a sample of the input signal would be converted to one of 256 levels, each level represented by an 8-bit value.

Vector quantization is a method of quantization, which is based on the linear and non-linear correlation between samples and the shape of the probability distribution. Essentially, vector quantization is a lookup process, where the lookup table is referred to as a "codebook". The codebook lists each quantization level, and each level has an associated "code-vector". The vector quantization process compares an input vector to the code-vectors and determines the best code-vector in terms of minimum distortion. Where x is the input vector, the comparison of distortion values may be expressed as:

$$d(x, y^{(j)}) < d(x, y^{(k)})$$

, for all j not equal to k. The codebook is represented by $y^{(j)}$, where $y^{(j)}$ is the jth code-vector, $0 < j < L$, and L is the number of levels in the codebook.

Multi-stage vector quantization (MSVQ) is a type of vector quantization. This process obtains a central quantized vector (the output vector) by adding a number of quantized vectors. The output vector is sometimes referred to as a "reconstructed" vector. Each vector used in the reconstruction is from a different codebook, each codebook corresponding to a "stage" of the quantization process. Each codebook is designed especially for a stage of the search. An input vector is quantized with the first codebook, and the resulting error vector is quantized with the second codebook, etc. The set of vectors used in the reconstruction may be expressed as:

$$y^{(j0,j1,...js-1)} = y_0^{(jn)} + y_1^{(j1)} + y_{s-1}^{(js-1)}$$

, where S is the number of stages and $y_s$ is the codebook for the sth stage. For example, for a three-dimensional input vector, such as x = (2,3,4), the reconstruction vectors for a two-stage search might be $y_0$ = (1,2,3) and $y_1$ = (1,1,1) (a perfect quantization and not always the case).

During multi-stage vector quantization, the codebooks may be searched using a sub-optimal tree search algorithm, also known as an M-algorithm. At each stage, M-best number of "best" code-vectors are passed from one stage to the next. The "best" code-vectors are selected in terms of minimum distortion. The search continues until the final stage, when only one best code-vector is determined.

In predictive quantization a target vector for quantization in the current frame is the mean-removed input vector minus a predictive value. The predicted value is the previous quantized vector multiplied by a known prediction matrix. In switched prediction, there is more than one possible prediction matrix and the best prediction matrix is selected for each frame. See S. Wang, et al., "Product Code Vector Quantization of LPC Parameters," in Speech and Audio Coding for Wireless and Network Applications," Ch. 31, pp. 251-258, Kluwer Academic Publishers, 1993.

It is highly desirable to provide an improved method for switched-predictive vector quantization.

SUMMARY OF THE INVENTION

In accordance with one embodiment of the present invention, an improved method and system of switched predictive quantization wherein prediction/codebook sets are switched to take advantage of time redundancy is provided.

DESCRIPTION OF THE DRAWINGS

Embodiments of the present invention will now be further described, by way of example, with reference to the accompanying drawings in which:

   Fig. 1 is a block diagram of Mixed Excitation Linear Prediction Coder;
   Fig. 2 is a block diagram of switch-predictive vector quantization encoder according to the present invention;
   Fig. 3 is a block diagram of a decoder according to the present invention; and
   Fig. 4 is a flow chart for determining a weighted distance measure in accordance with another embodiment of the present invention.

DESCRIPTION OF PREFERRED EMBODIMENTS OF THE PRESENT INVENTION

The new quantization method, like the one used in the 2.4 kb/s Federal Standard MELP coder, uses multi-stage vector quantization (MSVQ) of the Line Spectral Frequency (LSF) transformation of the LPC coefficients (LeBlanc, et al., entitled "Efficient Search and Design Procedures for Robust Multi-Stage VQ or LPC Parameters for 4kb/s Speech Coding," IEEE Transactions on Speech and Audio Processing, Vol. 1, No. 4, October 1993, pp. 373-385.) An efficient codebook search for multi-stage VQ is disclosed in U.S. Patent Application Serial No. 60/035,764.

However, the new method, according to preferred embodiments of the present invention, improves on the previous one in two ways: the use of switched prediction to take advantage of time redundancy and the use of a new weighted distance measure that better correlates with subjective speech quality.

In the Federal Standard MELP coder, the input LSF vector is quantized directly using MSVQ. However, there is a significant redundancy between LSF vectors of neighboring frames, and quantization accuracy can be improved by exploiting this redundancy. As discussed previously in predictive quantization, the target vector for quantization in the current frame is the mean-removed input vector minus a predicted value, where the predicted value is the previous quantized vector multiplied by a known prediction matrix. In switched prediction, there is more than one possible prediction matrix, and the best predictor or prediction matrix is selected for each frame. In accordance with preferred embodiments of the present invention, both the predictor matrix and the MSVQ codebooks are switched. For each input frame, we search every possible predictor/codebooks set combination for the predictor/codebooks set which minimizes the squared error. An index corresponding to this pair and the MSVQ codebook indices are then encoded for transmission. This differs from previous techniques in that the codebooks are switched as well as the predictors. Traditional methods share a single codebook set in order to reduce codebook storage, but we have found that the MSVQ codebooks used in switched predictive quantization can be considerably smaller than non-predictive codebooks, and that multiple smaller codebooks do not require any more storage space than one larger codebook. From our experiments, the use of separate predictor/codebooks pairs results in a significant performance improvement over a single shared codebook, with no increase in bit rate.

Referring to the LSF encoder with switched predictive quantizer 20 of Fig. 2, the 10 LPC coefficients are transformed by transformer 23 to 10 LSF coefficients of the Line Spectral Frequency (LSF) vectors. The LSF has 10 dimensional elements or coefficients (for 10 order all-pole filter). The LSF input vector is subtracted in adder 22 by a selected mean vector and the mean-removed input vector is subtracted in adder 25 by a predicted value. The resulting target vector for quantization vector e in the current frame is applied to multi-stage vector quantizer (MSVQ) 27. The predicted value is the previous quantized vector multiplied by a known prediction matrix at multiplier 26. The predicted value in switched prediction has more than one possible prediction matrix. The best predictor (prediction matrix and mean vector) is selected for each frame. In accordance with an embodiment of the present invention, both the predictor (the prediction matrix and mean vector) and the MSVQ codebook set are switched. A control 29 first switches in via switch 28 prediction matrix 1 and mean vector 1 and first set of codebooks 1 in quantizer 27. The index corresponding to this first prediction matrix and the MSVQ codebook indices for the first set of codebooks are then provided out of the quantizer to gate 37. The predicted value is added to the quantized output $\hat{e}$ for the target vector e at adder 31 to produce a quantized mean-removed vector. The mean-removed vector is added at Adder 70 to the selected mean vector to get quantized vector X. The squared error for each dimension is determined at squarer 35. The weighted squared error between the input vector $X_i$ and the delayed quantized vector $X_i$ is stored at control 29. The control 29 applies control signals to switch in via switch 28 prediction matrix 2 and mean vector 2 and codebook 2 set to likewise measure the weighted squared error for this set at squarer 35. The measured error from the first pair of prediction matrix 1 (with mean vector 1) and codebooks set 1 is compared with prediction matrix 2 (with mean vector 2) and codebook set 2. The set of indices for the codebooks with the minimum error is gated at gate 37 out of the encoder as encoded transmission of indices and a bit is sent out at terminal 38 from control 29 indicating from which pair of prediction matrix and codebooks set the indices was sent (codebook set 1 with mean vector 1 and predictor matrix 1 or codebook set 2 and prediction matrix 2 with mean vector 2). The mean-removed quantized vector from adder 31 associated with the minimum error is gated at gate 33a to frame delay 33 so as to provide the previous mean-removed quantized vector to multiplier 26.

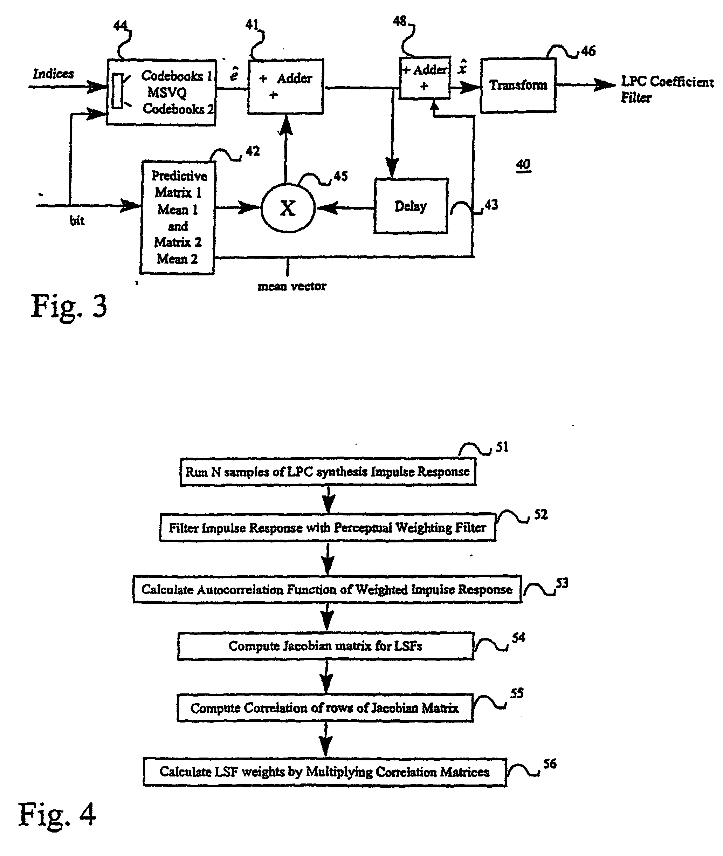

Fig. 3 illustrates a decoder 40 for use with LSF encoder 20. At the decoder 40, the indices for the codebooks from the encoding are received at the quantizer 44 with two sets of codebooks corresponding to codebook set 1 and 2 in the encoder. The bit from terminal 38 selects the appropriate codebook set used in the encoder. The LSF quantized input is added to the predicted value at adder 41 where the predicted value is the previous mean-removed quantized value (from delay 43) multiplied at multiplier 45 by the prediction matrix at 42 that matches the best one selected at the encoder to get mean-removed quantized vector. Both prediction matrix 1 and mean value 1 and prediction matrix 2 and mean value 2 are stored at storage 42 of the decoder. The 1 bit from terminal 38 of the encoder selects the prediction matrix and the mean value at storage 42 that matches the encoder prediction matrix and mean value. The quantized mean-removed vector is added to the selected mean value at adder 48 to get the quantized LSF vector. The quantized LSF vector is transformed to LPC coefficients by transformer 46.

As discussed previously, LSF vector coefficients correspond to the LPC coefficients. The LSF vector coefficients have better quantization properties than LPC coefficients. There is a 1 to 1 transformation between these two vector coefficients. A weighting function is applied for a particular set of LSFs for a particular set of LPC coefficients that correspond.

The Federal Standard MELP coder uses a weighted Euclidean distance for LSF quantization due to its computational simplicity. However, this distance in the LSF domain does not necessarily correspond well with the ideal measure of quantization accuracy: perceived quality of the processed speech signal. Applicant has previously shown in the paper on the new 2.4 kb/s Federal Standard that a perceptually-weighted form of log spectral distortion has close correlation with subjective speech quality. Applicant teaches herein in accordance with an embodiment a weighted LSF distance which corresponds closely to this spectral distortion. This weighting function requires looking into the details of this transformation for a particular set of LSFs for a particular input vector x which is a set of LSFs for a particular set of LPC coefficients that correspond to that set. The coder computes the LPC coefficients and as discussed above, for purposes of quantization, this is converted to LSF vectors which are better behaved. As shown in Fig. 1, the actual synthesizer will take the quantized vector $X$ and perform an inverse transformation to get an LPC filter for use in the actual speech synthesis. The optimal LSF weights for un-weighted spectral distortion are computed using the formula presented in paper of Gardner, et al., entitled, "Theoretical Analysis of the High-Rate Vector Quantization of the LPC Parameters," IEEE Transactions on Speech and Audio Processing, Vol. 3, No. 5, September 1995, pp. 367-381.

$$W_i = R_A(0)R_i(0) + 2\sum_{m=1}^{p-1} R_A(m)R_i(m)$$

where $R_A(m)$ is the autocorrelation of the impulse response of the LPC synthesis filter at lag m, and $R_i(m)$ is the correlation of the elements in the ith column of the Jacobian matrix of the transformation from LSF's to LPC coefficients. Therefore for a particular input vector x we compute the weight $W_i$.

A difference in a preferred embodiment of the invention is that perceptual weighting is applied to the synthesis filter impulse response prior to computation of the autocorrelation function $R_A(m)$, so as to reflect a perceptually-weighted form of spectral distortion.

In accordance with the weighting function as applies to the embodiment of Fig. 2, the weighting $W_i$ is applied to the squared error at 35. The weighted output from error detector 35 is

$$\sum W_i (X_i - \hat{X}_i)^2 \ .$$

Each entry in a 10 dimensional vector has a weight value. The error sums the weight value for each element. In applying the weight, for example, one of the elements has a weight value of three and the others are one then the element with three is given an emphasis by a factor of three times that of the other elements in determining error.

As stated previously, the weighting function requires looking into the details of the LPC to LSF conversion. The weight values are determined by applying an impulse to the LPC synthesis filter 21 and providing the resultant sampled output of the LPC synthesis filter 21 to a perceptual weighting filter 47. A computer 39 is programmed with a code based on a pseudo code that follows and is illustrated in the flow chart of Fig. 4. An impulse is gated to the LPC filter 21 and N samples of LPC synthesis filter response (step 51) are taken and applied to a perceptual weighting filter 37 (step 52). In accordance with one preferred embodiment of the present invention low frequencies are weighted more than high frequencies and in particular the preferred embodiment uses the well known Bark scale which matches how the human ear responds to sounds. The equation for Bark weighting $W_B(f)$ is

$$WB(f) = \frac{1}{25 + 75(1 + 1.4(\frac{f}{1000})^2)^{0.69}}$$

The coefficients of a filter with this response are determined in advance and stored and time domain coefficients are stored. An 8 order all-pole fit to this spectrum is determined and these 8 coefficients are used as the perceptual weighting filter. The following steps follow the equation for un-weighted spectral distortion from Gardner, et al. paper found on page 375 expressed as

$$W_i = R_A(0)R_i(0) + 2\sum_{m=1}^{p-1} R_A(m)R_i(m)$$

where $R_A(m)$ is the autocorrelation of the impulse response of the LPC synthesis filter at lag m, where

$$R_A(k) = \sum_{n=0}^{\alpha} h(n)h(n+k)$$

h(n) is an impulse response, $R_i(m)$ is

$$R_{J_i}(m) = \sum_{n=1}^{\nu-m} (J_\omega(\omega))_{n,i} (J_\omega(\omega))_{m+n,i}$$

$$= \sum_{n=1}^{\nu-m} j_i(n) j_i(m+n)$$

is the correlation function of the elements in the ith column of the Jacobian matrix $J_\omega(\omega)$ of the transformation from LSFs to LPC coefficients. Each column of $J_\omega(\omega)$ can be found by

$$= \begin{cases} \sin(\omega_i)e^{-j\omega} \prod_{j=0:\, j=(i+1)/2}^{\nu/2} \tilde{p}_j(\omega); i \text{ odd} \\ \sin(\omega_i)e^{-j\omega} \prod_{j=0:\, j=i/2}^{\nu/2} \tilde{q}_j(\omega); i \text{ even} \end{cases}$$

since

$$\prod_{j=0; j\neq i}^{v/2} \tilde{p}_j(\omega) = P(\omega) / \tilde{p}_i(\omega)$$

The values of $j_i(n)$ can be found by simple polynomial division of the coefficients of $P(\omega)$ by the coefficients of $\tilde{p}_i(\omega,)$. Since the first coefficient of $\tilde{p}_i(\omega) = 1$, no actual divisions are necessary in this procedure. Also, $j_i(n) = j_i(v + 1 - n) : i$ odd; $0 < n < v$, so only half the values must be computed. Similar conditions with an anti-symmetry property exist for the even columns.

The autocorrelation function of the weighted impulse response is calculated (step 53 in Fig. 4). From that the Jacobian matrix for LSFs is computed (step 54). The correlation of rows of Jacobian matrix is then computed (step 55). The LSF weights are then calculated by multiplying correlation matrices (step 56). The computed weight value from computer 39, in Fig. 2, is applied to the error detector 35. The indices from the prediction matrix/codebook set with the least error is then gated from the quantizer 27. The system may be implemented using a microprocessor encapsulating computer 39 and control 29 utilizing the following pseudo code. The pseudo code for computing the weighting vector from the current LPC and LSF follows:

```
/* Compute weighting vector from current LPC and LSF's */
Compute N samples of LPC synthesis filter impulse response
Filter impulse response with perceptual weighting filter
Calculate the autocorrelation function of the weighted
impulse response
Compute Jacobian matrix for LSF's
Compute correlation of rows of Jacobian matrix
Calculate LSF weights by multiplying correlation matrices
```

The code for the above is provided in Appendix A.
The pseudo code for the encode input vector follows:

```
/* Encode input vector */
For all predictor, codebook pairs
    Remove mean from input LSF vector
    Subtract predicted value to get target vector
    Search MSVQ codebooks for best match to target vector using
weighted distance
    If Error <Emin
        Emin = Error
        best predictor index = current predictor
    Endif
End
Endcode  best  predictor  index  and  codebook  indices  for
transmission
```

The pseudo code for regenerate quantized vector follows:

```
/* Regenerate quantized vector */
Sum MSVQ codevectors to produce quantized target
Add predicted value
Update memory of past quantized values (mean-removed)
Add mean to produce quantized LSF vector
```

We have implemented a 20-bit LSF quantizer based on this new approach which produces equivalent performance to the 25-bit quantizer used in the Federal Standard MELP coder, at a lower bit rate. There are two predictor/ codebook pairs, with each consisting of a diagonal first-order prediction matrix and a four stage MSVQ with codebook of size 64, 32, 16, and 16 vectors each. Both the codebook storage and computational complexity of this new quantizer are less than in the previous version.

Although the present invention and its advantages have been described in detail, it should be understood that various changes, substitutions and alterations can be made herein without departing from the scope of the invention.

For example it is anticipated that combinations of prediction matrix 1 may be used with codebook set 2 and prediction matrix 2 with codebook set 1 or any combination of codebook set and prediction matrix. There could be many more codebook sets and or prediction matrices. Such combinations require additional bits be sent from the encoder. There could be only one mean vector or many mean vectors. This switched predictive quantization can be used for vectors other than LSF but may also be applied to scalar quantization and in that case matrix as used herein may be a scalar value.

APPENDIX A

```
/*  Function vq_lspw: compute LSF weights

    Inputs:
      *p_lsp - LSF array
      *pc - LPC coefficients
      p - LPC model order

    Output:
      *w - array of weights

    Copyright 1997, Texas Instruments

*/

Float *vq_lspw(Float *w,Float *p_lsp,Float *pc,Int p)
{
    Int i,j,k,m;
    Float d, tmp, *tp, *ir, *R, *pz, *qz, *rem, *t, **J, **RJ;
    static Float bark_wt[8] = {
        -0.84602182,
        0.27873657,
        -0.10480262,
        0.05609138,
        -0.03315923,
        0.02132074,
        -0.01359822,
        0.00598910,
    };

    /* Allocate local array memory */
    MEM_ALLOC(MALLOC,ir,IRLENGTH+p,Float);
    ir=&ir[p];
    MEM_ALLOC(MALLOC,R,p,Float);
    MEM_ALLOC(MALLOC,pz,p+2,Float);
    MEM_ALLOC(MALLOC,qz,p+2,Float);
    MEM_ALLOC(MALLOC,rem,p+2,Float);
    MEM_ALLOC(MALLOC,t,3,Float);
    MEM_2ALLOC(MALLOC,J,p+1,p+1,Float);
    MEM_2ALLOC(MALLOC,RJ,p+1,p,Float);

    /* calculate IRLENGTH samples of the synthesis filter
    for (i=-p; i<IRLENGTH; i++)
        ir[i] = 0.0;                                    impulse response*/
    ir[0] = 1.0;
    for (i=0; i<IRLENGTH; i++)
    {
        for (j=1; j<=p; j++)
            ir[i] -= pc[j] * ir[i-j];
    }

    /* use all-pole model for frequency weighting */
    for (i=0; i<IRLENGTH; i++)
    {
        for (j=1; j<=8; j++)
            ir[i] -= bark_wt[j-1] * ir[i-j];
    }

    /* calculate the autocorrelation function of the impulse response */
    for (m=0; m<p; m++)                                /* for lags of 0 to p-1 */
    {
        R[m] = 0.0f;
        for (i=0; i<IRLENGTH-m; i++)
            R[m] += ir[i] * ir[i+m];
    }
```

## APPENDIX A

```
/* calculate   P(z) and Q(z) */
 for (1+1;  i<=p; i++)
 {
     pz(1) = pc[1] + pc[p+1-i];
     qz(1) = pc[1] - pc[p+1-i];
 }
pz[0] = qz[0] = pz[p+1] = 1.0f;
qz[p+1] = -1.0f;

/* calculate the J matrix */
/* use the rows of J to store the polynomials */
/* (rather than the columns, as in Gardner) */
t[0] = t[2] = 1.0f;
for (i=1; i<=p; i++)                      /* for all the rows of J */
{
    t[1] = -2.0f * cos(PI * p_lsp[i]);
    tmp = sin(PI * p_lsp[i]);
    if (i != 2 * (i/2)) tp = pz;           /* i is odd;  use p(z) */
    else                tp = qz;           /* i is even; use q(z) */
    /* divide polynomial tp by polynomial t and put the result into */
    /* row J[i] */
    for (j=0; j<=p+1; j++)
        rem[j] = tp[j];
    for (k=p; k>=1; k--)
    {
        J[i][k] = rem[k+1];
        for (j=k; j>=k-1; j--)
            rem[j] -= J[i][k] * t[j-k+1];
    }
    /* multiply the ith row by the sin() term */
    for (j=1; j<=p; j++)
        J[i][j] *= tmp;
}

/* determine the 'correlation' function of the rows of J */
for (i=1; i<=p; i++)                            /* for each row */
{
    for (m=0; m<p; m++)                         /* for each lag */
    {
        RJ[i][m] = 0.0f;
        /* for each element in the row */
        for (j=1; j<=p-m; j++)
            RJ[i][m] += J[i][j] * J[i][j+m];
    }
}
/* finish the weight calculation */
for (i=1; i<=p; i++)
{
    tmp = 0.0f;
    for (m=1; m<p; m++)
        tmp += R[m] * RJ[i][m];
    w[i-1] = R[0] * RJ[i][0] + 2.0f * tmp;

}

/* Free local memory */
ir=&ir[-p];
MEM_FREE(FREE,ir);
MEM_FREE(FREE,R);
MEM_FREE(FREE,pz);
MEM_FREE(FREE,qz);
MEM_FREE(FREE,rem);
MEM_FREE(FREE,t);
MEM_2FREE(FREE,J);
MEM_2FREE(FREE,RJ);

return(w);
```

**Claims**

1.  A switched predictive method for quantizing an input comprising the steps of:

     providing a mean value and subtracting said mean value from said input to obtain a mean-removed input;
     providing a quantizer with a first and second set of codebooks;
     providing a first and second prediction matrix;
     multiplying a previous frame mean-removed quantized value to said first prediction matrix then said second prediction matrix to obtain first predicted values and second predicted values;
     subtracting said predicted values from said mean-removed input to obtain target values;
     applying said target values to said codebook sets to obtain quantized target values;
     adding said predicted values to said quantized target values to obtain mean-removed quantized values;
     adding a mean value to said mean-removed quantized values to obtain quantized values; and
     determining which codebook set and prediction matrix has minimum error and providing the quantized output corresponding to that set with minimum error.

2.  The method of Claim 1 wherein said input comprises LSF coefficients corresponding to a set of LPC coefficients.

3.  The method of Claim 2 wherein said determining step comprises the step of determining the squared error for each dimension between the input vector and the quantized output.

4.  The method of Claim 3 further comprising: multiplying said squared error by a weighting value for each dimension.

5.  The method of Claim 4 wherein the weighting function is a Euclidean distance for LSF quantization.

6.  The method of Claim 3 wherein said weighting function is a weighted LSF distance which *corresponds* closely to a perceptually weighted form of spectral distortion.

7.  Apparatus for switched-predictive quantization of an input value, comprising:

     a first and a second codebook,
     a first and a second prediction means
     switching means operable for the prediction means,
     error calculation means, and
     input modification means, wherein the apparatus is configurable to switch said first or second prediction means outputs to said input modification means to respectively modify said input value in accordance with respective first for second prediction means for providing a first or second target value, and further configurable to derive quantized first or second target values from respective first or second codebooks and to derive a quantized first or second input value from said quantized first or second target values and to input said quantized first or second input value and said input value to said error calculation means for deriving a difference therebetween.

**Patentansprüche**

1.  Verfahren für die geschaltete Vorhersage zum Quantisieren eines Eingangssignals, das die folgenden Schritte umfaßt:

     Vorsehen eines Mittelwerts und Subtrahieren des Mittelwerts von dem Eingangssignal, um ein um den Mittelwert reduziertes Eingangssignal zu erhalten;

     Vorsehen eines Quantisierers mit einer ersten und einer zweiten Menge von Codebüchern;

     Vorsehen einer ersten und einer zweiten Vorhersagematrix;

     Multiplizieren eines um den Mittelwert reduzierten quantisierten Wertes eines vorhergehenden Rahmens mit der ersten Vorhersagematrix und dann mit der zweiten Vorhersagematrix, um einen ersten vorhergesagten Wert bzw. einen zweiten vorhergesagten Wert zu erhalten;

Subtrahieren der vorhergesagten Werte von dem um den Mittelwert reduzierten Eingangssignal, um Sollwerte zu erhalten;

Eingeben der Sollwerte in die Codebuch-Mengen, um quantisierte Sollwerte zu erhalten;

Addieren der vorhergesagten Werte zu den quantisierten Sollwerten, um um den Mittelwert reduzierte quantisierte Werte zu erhalten;

Addieren eines Mittelwerts zu den um den Mittelwert reduzierten Werten, um quantisierte Werte zu erhalten; und

Bestimmen, welche Codebuch-Menge und welche Vorhersagematrix einen minimalen Fehler haben, und Versehen des quantisierten Ausgangssignals, das dieser Menge entspricht, mit dem minimalen Fehler.

2. Verfahren nach Anspruch 1, bei dem das Eingangssignal LSF-Koeffizienten umfaßt, die einer Menge von LPC-Koeffizienten entsprechen.

3. Verfahren nach Anspruch 2, bei dem der Bestimmungsschritt den Schritt umfaßt, bei dem der quadrierte Fehler für jede Dimension zwischen dem Eingangsvektor und dem quantisierten Ausgangssignal bestimmt wird.

4. Verfahren nach Anspruch 3, das ferner umfaßt: Multiplizieren des quadrierten Fehlers mit einem Gewichtungswert für jede Dimension.

5. Verfahren nach Anspruch 4, bei dem die Gewichtungsfunktion ein euklidischer Abstand für die LSF-Quantisierung ist.

6. Verfahren nach Anspruch 3, bei dem die Gewichtungsfunktion ein gewichteter LSF-Abstand ist, der weitgehend einer durch Wahrnehmung gewichteten Form einer spektralen Verzerrung entspricht.

7. Vorrichtung für die geschaltete vorhergesagte Quantisierung eines Eingangswertes, mit:

einem ersten und einem zweiten Codebuch,

einem ersten und einem zweiten Vorhersagemittel,

Schaltmitteln, die für die Vorhersagemittel arbeiten können,

Fehlerberechnungsmitteln und

Eingangssignal-Modifikationsmitteln, wobei die Vorrichtung so konfigurierbar ist, daß sie die Ausgangssignale des ersten oder des zweiten Vorhersagemittels zu den Eingangssignal-Modifikationsmitteln schaltet, um den Eingangswert in Übereinstimmung mit dem ersten bzw. dem zweiten Vorhersagemittel zu modifizieren, um einen ersten oder einen zweiten Sollwert zu schaffen, und ferner so konfigurierbar ist, daß sie einen quantisierten ersten oder zweiten Sollwert aus dem entsprechenden ersten oder zweiten Codebuch ableitet und einen quantisierten ersten oder zweiten Eingangswert aus dem quantisierten ersten oder zweiten Sollwert ableitet und den quantisierten ersten oder zweiten Eingangswert sowie den Eingangswert in die Fehlerberechnungsmittel eingibt, um eine Differenz dazwischen abzuleiten.

**Revendications**

1. Procédé prédictif commuté pour quantifier une entrée, comprenant les étapes :

de fourniture d'une valeur moyenne et de soustraction de ladite valeur moyenne de ladite entrée pour obtenir une entrée à suppression de moyenne ;
de fourniture d'un quantificateur avec une première et une deuxième séries de livres de code ;
de fourniture d'une première et d'une deuxième matrices de prédiction ;
de multiplication d'une valeur quantifiée à suppression de moyenne de trame précédente avec ladite première matrice de prédiction puis avec ladite deuxième matrice de prédiction pour obtenir des premières valeurs prédites et des deuxièmes valeurs prédites ;

de soustraction desdites valeurs prédites de ladite entrée à suppression de moyenne pour obtenir des valeurs cibles ;

d'application desdites valeurs cibles auxdites séries de livres de code pour obtenir des valeurs cibles quantifiées ;

d'addition desdites valeurs prédites auxdites valeurs cibles quantifiées pour obtenir des valeurs quantifiées à suppression de moyenne ;

d'addition d'une valeur moyenne auxdites valeurs quantifiées à suppression de moyenne pour obtenir des valeurs quantifiées ; et

de détermination de celle parmi la série de livres de code et de la matrice de prédiction qui a une erreur minimum et fourniture de la sortie quantifiée correspondant à cette série avec une erreur minimum.

2. Procédé selon la revendication 1, dans lequel ladite entrée comprend des coefficients LSF correspondant à une série de coefficients LPC.

3. Procédé selon la revendication 2, dans lequel ladite étape de détermination comprend l'étape de détermination de l'erreur quadratique pour chaque dimension entre le vecteur d'entrée et la sortie quantifiée.

4. Procédé selon la revendication 3, comprenant en outre : la multiplication de ladite erreur quadratique par une valeur de pondération pour chaque dimension.

5. Procédé selon la revendication 4, dans lequel la fonction de pondération est une distance euclidienne pour une quantification LSF.

6. Procédé selon la revendication 3, dans lequel ladite fonction de pondération est une distance LSF pondérée qui correspond étroitement à une forme perceptuellement pondérée de distorsion spectrale.

7. Appareil pour une quantification prédictive commutée d'une valeur d'entrée, comprenant :

un premier et un deuxième livres de code,
un premier et un deuxième moyens de prédiction,
un moyen de commutation pouvant fonctionner pour le moyen de prédiction,
un moyen de calcul d'erreur, et
un moyen de modification d'entrée, dans lequel l'appareil peut être configuré pour commuter les sorties dudit premier ou dudit deuxième moyen de prédiction audit moyen de modification d'entrée pour modifier respectivement ladite valeur d'entrée en fonction dudit premier ou dudit deuxième moyen respectif de prédiction pour obtenir une première ou une deuxième valeur cible, et pouvant en outre être configuré pour obtenir une première ou une deuxième valeur cible quantifiée à partir du premier ou du deuxième livre de code respectif et pour obtenir une première ou une deuxième valeur d'entrée quantifiée à partir de ladite première ou de ladite deuxième valeur cible quantifiée et pour introduire ladite première ou ladite deuxième valeur d'entrée quantifiée et ladite valeur d'entrée dans ledit moyen de calcul d'erreur pour obtenir une différence entre elles.

Fig. 1

Fig. 2

Fig. 3

Fig. 4